# EUROPEAN PATENT APPLICATION

(11) **EP 4 844 098 A1**
(43) Date of publication of application: **25.11.2026**
(21) Application number: 26174533.5
(22) Date of filing: 24.04.2026
(51) Int. Cl.: C23C 16/455

(54) **VAPOR INJECTOR SYSTEM**

(30) Priority: 29.04.2025 GR 20250100311
(71) Applicant: ASM IP Holding B.V., 1322 AP Almere (NL)
(72) Inventor: KARAGIANNIS, Angelos, 1322 AP Almere (NL); JDIRA, Lucian, 1322 AP Almere (NL); OOSTERLAKEN, Theodorus G.M., 1322 AP Almere (NL); TERHORST, Herbert, 1322 AP Almere (NL)
(74) Representative: V.O.

(57) **Abstract**

The present invention relates to injector systems injector system for injecting a vapor into a process chamber, and substrate processing systems containing the process chamber and the injector system for providing a vapor into the process chamber. The injector system comprises at least a first and a second injector, each comprising an elongated internal conduit, a series of inlets, distributed along the conduit, for providing the vapor into the conduit, and a series of vapor injection openings, distributed along the conduit, for providing the vapor from the conduit into the process chamber. The injector system further comprises a vapor distributor for providing the vapor to the inlets of the injectors. The series of vapor injection openings of the first and second injector are arranged substantially parallel to each other, wherein the openings of the first injector alternate with the openings of the second injector.

## Description

### Technical field of the invention

The present invention relates to the field of vapor deposition, and more specifically to injector systems for delivering vapor into a process chamber.

### Background of the invention

Chemical vapor deposition (CVD), such as atomic layer deposition (ALD), is widely used in semiconductor manufacturing for depositing thin films onto substrates. In batch processing systems, multiple wafers are processed simultaneously, increasing manufacturing throughput compared to single-wafer processing. These batch systems typically utilize vapor injection systems to deliver precursor gases and reactants to the processing chamber.

Vapor injection systems in batch furnaces commonly consist of elongated ducts or tubes positioned within the processing chamber, featuring a series of vapor injection openings through which the process gases exit into the process chamber. The design and configuration of these injection systems influence process parameters such as deposition uniformity, film quality, and overall process efficiency.

As semiconductor manufacturing technology advances, batch furnaces are designed to accommodate increasingly larger wafer loads. Modern batch systems may process over 150 wafers simultaneously, which presents challenges for gas distribution systems. The geometry, positioning, and design of the injection system become important factors in achieving consistent processing results across all wafers in the batch.

Indeed, one challenge in vapor injection systems relates to gas flow dynamics within the injector conduits. Injectors typically contain an inlet at an end of the conduit for providing vapor into the conduit. Then, along the conduit, in a direction directing away from the inlet, the vapor pressure drops along each vapor injection opening. In case of a uniform conduit width and uniform vapor injection openings, this may result in a lower vapor flow rate through openings farther away from the inlet.

Traditional approaches to address this challenge often involve varying the number, spacing, or dimensions of vapor injection openings along the injector length. However, as wafer batch sizes increase, the practical implementation of such variable-geometry approaches becomes more complex, particularly when attempting to maintain precise dimensional control across numerous openings.

The positioning of injectors relative to wafer locations presents another consideration. In some processes, aligning injection points with wafer positions may be beneficial for optimizing precursor delivery efficiency. However, achieving such alignment while maintaining uniform gas distribution becomes increasingly challenging as the number of wafers increases.

The physical volume occupied by injection systems within the process chamber represents another consideration. The presence of multiple injector assemblies may impact gas flow patterns within the chamber, affect temperature uniformity, or reduce the available space for wafer loading.

Challenges remain in developing vapor injection systems that can deliver uniform gas distribution across large wafer batches while accommodating various process requirements and practical manufacturing constraints. Addressing some of these challenges would benefit semiconductor manufacturing processes that rely on batch CVD, e.g., batch ALD, technologies.

### Summary of the invention

It is an objective of embodiments of the present invention to provide good injector systems, and substrate processing systems, for injecting a vapor into a process chamber.

This objective is accomplished by the devices of the present invention.

It is an advantage of embodiments of the present invention that enhanced uniformity may be achieved in multi-substrate processing operations.

It is an advantage of embodiments of the present invention that a uniform precursor flow along the entire length of the injector into a process chamber can be provided.

It is an advantage of embodiments of the present invention that film uniformity on substrates may be improved.

It is an advantage of embodiments of the present invention that a single-hole-per-wafer injection can be maintained even for large wafer loads.

It is an advantage of embodiments of the present invention that the geometry of injection ports can remain largely standardized, reducing complexity and fabrication cost.

It is an advantage of embodiments of the present invention that the space occupied by multiple injectors in the processing chamber can be minimized.

In a first aspect, the present invention relates to an injector system for injecting a vapor into a process chamber, the injector system comprising at least a first and a second injector, each comprising an elongated internal conduit, a series of inlets, distributed along the conduit, for providing the vapor into the conduit, and a series of vapor injection openings, distributed along the conduit, for providing the vapor from the conduit into the process chamber, and a vapor distributor for providing the vapor to the inlets of the injectors, wherein the series of vapor injection openings of the first and second injector are arranged substantially parallel to each other, wherein - in a direction along said series of vapor injection openings - the openings of the first injector alternate with the openings of the second injector.

In a second aspect, the present invention relates to a substrate processing system comprising a process chamber, and the injector system of the first aspect for providing a vapor into the process chamber.

In a third aspect, the present invention relates to an injector system for injecting a vapor into a process chamber, the injector system comprising at least one injector comprising an elongated internal conduit, an inlet along the conduit for providing the vapor into the conduit, a series of vapor injection openings, distributed along the conduit, for providing the vapor from the conduit into the process chamber, and a flow deflector at the inlet for deflecting a flow of said vapor, entering the conduit through the inlet, in a direction along the conduit.

In a fourth aspect, the present invention relates to an injector system for injecting a vapor into a process chamber, the injector system comprising at least one injector comprising an elongated internal conduit, a series of inlets, distributed along the conduit, for providing the vapor into the conduit, and a series of vapor injection openings, distributed along the conduit, for providing the vapor from the conduit into the process chamber, and a vapor distributor for providing the vapor to the inlets of the injectors.

In a fifth aspect, the present invention relates to a substrate processing system comprising a process chamber, and the injector system of the third or fourth aspect for providing a vapor into the process chamber.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

FIG. 1A is a front view of an injector system for injecting a vapor into a process chamber according to embodiments of the present invention.
FIG. 1B is a perspective view of an injector system for injecting a vapor into a process chamber according to embodiments of the present invention.
FIG. 1C is a side view of an injector system for injecting a vapor into a process chamber according to embodiments of the present invention.
FIG. 2 is an exploded view of an injector system for injecting a vapor into a process chamber according to embodiments of the present invention.
FIG. 3 is a close-up front view of an injector system showing the alternating arrangement of vapor injection openings between first and second injectors according to embodiments of the present invention.
FIG. 4 is a close-up perspective view of an injector system showing inlets of the second pre-injector chamber according to embodiments of the present invention.
FIG. 5 is a close-up perspective view of an injector system showing the coupling between the first and second pre-injector chambers according to embodiments of the present invention.
FIG. 6 is a close-up perspective view of an injector system showing the central inlet of the first injector according to embodiments of the present invention.
FIG. 7 is a close-up perspective view of an injector system showing an upper inlet of an injector according to embodiments of the present invention.
FIG. 8A is a close-up perspective view of an injector system showing a flow deflector at an inlet according to embodiments of the present invention.
FIG. 8B is a close-up perspective view of a flow deflector according to embodiments of the present invention.
FIG. 9 is a schematic representation of vapor flow in an injector system without flow deflectors according to embodiments of the present invention.
FIG. 10 is a schematic representation of vapor flow in an injector system with flow deflectors according to embodiments of the present invention.
FIG. 11 is a representation of computational fluid dynamics calculations for vapor flow in an injector system according to embodiments of the present invention.
FIG. 12 is a representation of computational fluid dynamics calculations for vapor flow in an injector system according to embodiments of the present invention.
FIG. 13 is a graph showing outflow patterns of an injector with and without a flow deflector according to embodiments of the present invention.
FIG. 14 is a graph showing uniformity of outflow across vapor injection openings according to embodiments of the present invention.
FIG. 15 is a vertical cross-sectional view of a process chamber comprising an injector system in accordance with embodiments of the present invention.
FIG. 16 is a cutaway view of part of the process chamber, showing part of the injector system in accordance with embodiments of the present invention and part of the substrates in front of the vapor injection openings of the injector system.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Similarly, it is to be noticed that the term "coupled", also used in the claims, should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

In a first aspect, the present invention relates to an injector system for injecting a vapor into a process chamber, the injector system comprising at least a first and a second injector, each comprising an elongated internal conduit, a series of inlets, distributed along the conduit, for providing the vapor into the conduit, and a series of vapor injection openings, distributed along the conduit, for providing the vapor from the conduit into the process chamber, and a vapor distributor for providing the vapor to the inlets of the injectors, wherein the series of vapor injection openings of the first and second injector are arranged substantially parallel to each other, wherein - in a direction along said series of vapor injection openings - the openings of the first injector alternate with the openings of the second injector.

In embodiments, the vapor may comprise any vapor-phase or gas-phase substance that is to be introduced into the process chamber. Said vapor may be for processing substrates, e.g., for depositing a layer on the substrates or for etching the substrates, but that is not essential. In embodiments, the vapor may comprise a reactive gas, such as a vapor-phase precursor that may be used in chemical vapor deposition. In embodiments, the vapor may comprise active species for cleaning, depositing, or etching processes. In some embodiments, the vapor may comprise an inert gas, such as nitrogen or argon.

In embodiments, the elongated internal conduit may be a fluidic channel or tube contained in the injector. In embodiments, the elongated internal conduit extends in a substantially linear or curved manner. In embodiments, the conduit is arranged for receiving the vapor from each of the inlets, and for conducting the vapor, typically along an elongated axis of the conduit, to each of the vapor injection openings. In embodiments, each of the inlets is fluidically coupled, via the internal conduit, to each of the vapor injection openings. The conduit may have any shape, such as a cylindrical or cuboid shape. The wall of the elongated internal conduit may be a tube that may be made of any material chemically resistive towards the vapor. For example, the wall may be a metal alloy capable of withstanding high temperatures, or a structured ceramic conduit designed for highly corrosive environments. In embodiments, the injector may comprise, or may be formed of, quartz, or silicon, or silicon carbide.

Typically, the series of inlets comprises a plurality of inlets. In embodiments, the inlets may be openings or ports or holes or apertures in a wall of the injector, distributed along the elongated internal conduit, through which vapor is supplied from the vapor distributor into the conduit. Typically, the inlets are distributed along the elongated axis of the conduit. In embodiments, each inlet may be positioned or arranged to introduce vapor perpendicularly or tangentially into the conduit, that is, perpendicular to the elongated axis. In embodiments, the inlets may have a same size. In embodiments, the inlets may vary in size or shape, adapted to provide a uniform flow of the vapor through the vapor injection openings along each injector.

Typically, the series of vapor injection openings comprises a plurality of vapor injection openings. In embodiments, for each injector, the vapor injection openings may be arranged so that the vapor leaves the conduit through the vapor injection openings of the injector, e.g., so that the vapor is injected into the process chamber, in a direction substantially perpendicular to the conduit, or substantially perpendicular to the elongated axis of the conduit. The vapor injection openings may be openings or ports or holes or apertures in a wall of the injector along the conduit, arranged for directing the vapor from the conduit into the process chamber. In embodiments, for each injector, the vapor injection openings may be arranged along a straight line. This arrangement may simplify fabrication and may facilitate alignment with substrates. In embodiments, for each injector, the vapor injection openings may be arranged at regular intervals along the conduit. This regular spacing ensures consistent vapor distribution to the substrates.

The vapor injection openings may have a uniform size, or may vary in diameter, e.g., may be adapted to provide a uniform flow of the vapor through the vapor injection openings along each injector. The vapor injection openings may be arranged in a linear pattern or otherwise configured to match specific substrate load geometries. It is an advantage of embodiments of the present invention that by using the series of inlets, fluidically coupled to the vapor distributor, the vapor injection openings may have a uniform size and shape while still providing a uniform injection of vapor along the elongated axis of the conduit.

The series of vapor injection openings of the injectors, i.e., of at least the first and second injector but also of further injectors if present, are typically arranged substantially parallel to each other. In other words, the series of vapor injection openings of the first injector may be substantially parallel to the series of vapor injection openings of the second injector, and to the series of vapor injection opening of each other injector, if present. In embodiments, the series of vapor injection openings of the different injectors are provided along, or adjacent to, each other. For example, the series of vapor injection openings of the first injector may be located along, or adjacent to, the series of vapor injection openings of the second injector.

For each injector, a line, e.g., a substantially straight line, may be drawn through the series of vapor injection openings, e.g., crossing each of the vapor injection openings of the injector. For each injector, the series of vapor injection openings may be arranged along said line, e.g., a substantially straight line. In embodiments, said lines for the different injectors are substantially parallel to each other. Said line typically runs parallel to the conduit's central axis. In embodiments, the series or pattern of openings along the conduit's elongated axis defines this direction. In embodiments, an angle between the axes may be at most 40°, preferably at most 20°, more preferably at most 10°, even more preferably 0°. A parallel arrangement may improve uniformity of the injected vapor.

In embodiments, the conduits of the injectors are arranged substantially parallel, e.g., at an angle of at most 40°, preferably at most 20°, more preferably at most 10°, even more preferably 0°, with respect to each other. The conduits may be arranged along each other. For example, the conduit of the first injector may be arranged along the conduit of the second injector. In embodiments, the injectors are arranged substantially parallel, e.g., at an angle of at most 40°, preferably at most 20°, more preferably at most 10°, even more preferably 0°, with respect to each other. For example, the first injector may be arranged along the second injector. This arrangement may result in a good and efficient use of the limited available space in the process chamber.

Typically, the injectors are located proximate to, or adjacent to, or along, each other. For example, the injectors may be located at a same side of the process chamber. This may provide a good vapor flow uniformity within the process chamber.

In embodiments, the series of vapor injection openings of the injectors are arranged substantially vertically in the process chamber. In embodiments, the conduits of the injectors are arranged substantially vertically in the process chamber. In embodiments, the injectors are arranged substantially vertically in the process chamber.

In embodiments, the injector openings of the different injectors alternate with each other in a direction along each series of vapor injection openings, or along the elongated axis of the conduits, or along the vertical direction. In embodiments, the vapor injection openings of the first injector alternating with the vapor injection openings of the second injector may indicate a sequence in which adjacent vapor injection openings along said direction belong to different injectors in a repeating pattern. In embodiments, a vapor injection opening from the first injector is followed by a vapor injection opening from the second injector, followed again by a vapor injection opening from the first injector, and so on, thereby distributing vapor more evenly across a substrate stack that may be located in the process chamber. In embodiments comprising more than two injectors, the vapor injection openings of the different injectors may alternate in a regular pattern. For example, in embodiments, a vapor injection opening from the first injector may be followed by a vapor injection opening from the second injector, followed by a vapor injection opening from a third injector, followed again by a vapor injection opening from the first injector, and so on. This alternating of vapor injection openings may limit the number of vapor injection openings that need to be present in a single injector, while still a homogeneous flow of the vapor may be provided into the process chamber. Indeed, if, for each substrate present in the process chamber, a vapor injection opening is to be provided, the number of vapor injection openings may be very large, and the pitch between the vapor injection opening may be very small. This may be a problem for manufacturing the injectors, and for providing a uniform vapor flow into the process chamber.

In embodiments, each injector may comprise a flow deflector at at least one inlet, e.g., at each inlet, for deflecting a flow of said vapor, entering the conduit through the inlet, in a direction along the conduit. In embodiments, the flow deflector may be a plate, baffle, or vane, positioned or arranged for said deflecting of the vapor flow. These embodiments may provide an improved flow distribution within the conduit and a more homogeneous vapor flow through the vapor injection openings into the process chamber. The inlets are typically arranged along the conduit, and arranged such that vapor flows into the conduit in a direction perpendicular to the elongated axis of the conduit. Thereby, the vapor may be directed through the inlet directly towards the series of vapor injection openings, that are distributed along the conduit as well, and that are typically located at the opposite side of the conduit, that is, at the opposite side of the axis of the conduit, opposite from the inlets. As such, the vapor flowing through the inlet into the conduit may be directed towards the vapor injection openings. This may result in a higher vapor flow through the vapor injection openings proximate to the inlet than for vapor injection openings farther away from the inlet. The flow deflector may deflect the vapor flow, thereby redirecting or bending the path of the vapor entering the conduit, so that the vapor proceeds in a direction along the axis of the conduit, or along the elongated axis. By way of a non-limiting example, deflecting may involve turning vapor flow from a perpendicular orientation to a substantially longitudinal orientation, along the elongated axis, to increase uniformity in injection rates.

In embodiments, for each injector, the series of inlets may be distributed substantially symmetrically along the conduit, e.g., substantially mirror symmetrically with respect to a mirror plane perpendicular to the elongated axis of the conduit. In embodiments, the series of inlets may be divided into upper inlets and lower inlets, with the upper inlets being mirrored with respect to said mirror plane located between the upper and lower inlets. Said mirror plane may be located substantially at a central portion, e.g., at a midpoint, along the series of vapor injection openings, e.g., along the conduit. This may ensure uniform vapor distribution throughout the injector system. In embodiments, for each injector, the series of inlets may comprise at least one pair of inlets, wherein each inlet of each pair is located substantially equidistant from a midpoint of the conduit. This arrangement may provide flow rate symmetry and flow rate uniformity. In embodiments, each injector comprises a vapor injection opening at said central portion, e.g., at the midpoint.

Said midpoint along the series of vapor injection openings may be a reference position along the series that is equidistant from its two most outer or outmost vapor injection openings, e.g., from the first and last opening of the series. The midpoint of the conduit may be a reference position along the conduit's length that is equidistant from its two endpoints. In embodiments, for each injector, the series of inlets may comprise a central inlet substantially at said midpoint.

In embodiments, for each injector, the series of inlets may be located on a substantially opposite side of the conduit with respect to the series of vapor injection openings. In embodiments, the series of inlets may be located on a first side of a plane that is parallel to the elongated axis of the conduit, and the series of vapor injection openings may be located on a second side of said plane, different from the first side.

In embodiments, the injector system may be arranged so that, when vapor is provided to the vapor distributor, a volumetric flow rate of the vapor flowing through the vapor injection openings is substantially the same for each vapor injection opening. This may result in a uniform deposition across all substrates in the process chamber. The embodiments may provide a uniform or near-uniform flow distribution across all injection points, i.e., vapor injection openings, within acceptable tolerances. By way of example, such uniformity can be achieved using adapted inlet sizes, adapted sizes of vapor injection openings, an adapted internal width of the conduit, and/or or adapted flow paths in the vapor distributor.

In embodiments, the vapor distributor may be a component or assembly that may be configured for receiving vapor from a vapor source and apportions or routes that vapor to the inlets of the injectors. In some embodiments, the vapor distributor may include multiple chambers or manifolds connected via fluid couplings to ensure substantially uniform delivery of vapor to each injector.

In preferred embodiments, the vapor distributor may comprise, for each injector, a first pre-injector chamber, arranged parallel to the conduit of the injector, fluidically coupled to the series of inlets of the injector, and a second pre-injector chamber, fluidically coupled to a central portion of the first pre-injector chamber of each injector, the second pre-injector chamber further comprising an inlet for receiving the vapor. The inlet of the second pre-injector chamber may be fluidically coupled to the vapor source. This multi-stage distribution system may ensure uniform vapor flow across all injectors.

In embodiments, each pre-injector chamber may comprise an auxiliary manifold, chamber, duct or conduit, or volume arranged adjacent or along, and preferably substantially parallel to, the elongated conduit. The pre-injector chamber receives vapor from a vapor source before feeding it into the inlets of the conduit. Examples include cylindrical or rectangular ducts that run alongside the conduit of the injector, providing a buffer region to stabilize, distribute or regulate the vapor flow.

Typically, at least the first and second injector are, e.g., each injector of the injector system is, fluidically connected to the same vapor distributor, which may distribute the vapor to at least the first and second injector, e.g., to each injector, so as to provide a uniform flow rate through each of the vapor injection openings. Hence, the first and second injector may, via the vapor distributor, be fluidically coupled to the same vapor source.

Although two injectors may be preferred for reasons of limited space of volume, the injector system may contain more than two injectors, fluidically connected to the same vapor distributor. In embodiments, the series of vapor injection openings of each of the injectors is arranged substantially parallel to each other. For example, a system with four parallel injectors fluidically coupled to the same vapor distributor still falls under the scope of having at least a first and a second injector.

Each of the injectors may have substantially corresponding features and/or a same arrangement. Each of the injectors may have a same number and/or arrangement of vapor injection openings. Each of the injectors may have a same number and/or arrangement of inlets.

Any features of any embodiment of the first aspect may be independently as correspondingly described for any embodiment of any of the other aspects of the present invention.

In a second aspect, the present invention relates to a substrate processing system comprising a process chamber, and the injector system of the first aspect for providing a vapor into the process chamber.

In embodiments, the substrate processing system comprises a vapor source fluidically coupled to the injector system, e.g., to the vapor distributor of the injector system. The vapor source may be any type of vapor source suitable for providing the vapor to the injector system. In embodiments, the vapor source may comprise a gas cylinder, a precursor vessel, a solid source vaporizer, or a bubbler system.

In embodiment, the substrate processing system may comprise a valve between the vapor source and the injections. Said valve may be located between the vapor source and the injector system, e.g., upstream of the vapor distributor. The valve may be located within the vapor distributor. A valve may be located at the inlets of each injector.

The substrate processing system may comprise a controller configured for providing the vapor into the injector system, or into the process chamber via the injector system. The substrate processing system may comprise a controller configured for controlling the valve, adapted for opening the valve for providing the vapor into the injector system, or into the process chamber via the injector system, and for closing the valve for terminating said providing of the vapor.

In embodiments, the process chamber may be configured for receiving a substrate carrier supporting a stack of a plurality of substrates. In embodiments, the process chamber comprises said substrate carrier. In embodiments, the substrate carrier comprises the stack of a plurality of substrates. In embodiments, the substrates are separated from each other by gaps, wherein the series of vapor injection openings of the injectors are arranged along said stack. In embodiments, - in a direction along said stack - a pitch between the vapor injection openings of the injector system is substantially the same as (e.g., within 20% of, preferably within 10% of, more preferably the same as) a pitch between the substrates. The pitch between vapor injection openings of the injector system is typically the center-to-center distance between successive openings on the injector system. As the vapor injection openings alternate between the different injectors of the injector system, the pitch between the vapor injection openings of the injector system is typically the pitch between a vapor injection opening of the first injector and a vapor injection opening of the second injector, in a direction along or parallel to the injectors, e.g., along a vertical direction. The pitch between the substrates is typically the center-to-center distance between successive substrates of the stack. In embodiments, the pitch between the vapor injection openings of each injector may be twice the pitch between the substrates. The pitch between the vapor injection openings of a single injector is typically the center-to-center distance between successive vapor injection openings along the injector or along the conduit.

In these embodiments, each substrate may be associated with a dedicated vapor injection opening for providing said vapor to the substrate. In embodiments, the injectors may be arranged so that each vapor injection opening faces a gap between substrates in the carrier. In embodiments, each gap between the substrates may be associated with a vapor injection opening for providing the vapor in the gap. This alignment may ensure that each substrate receives a uniform vapor flow, and that the vapor may be provided uniformly to the different substrates of the stack. The substrates may be semiconductor wafers, such as a silicon wafers, gallium arsenide wafers, silicon carbide wafers, germanium wafers, or indium phosphide wafers, or combinations thereof, although the invention is not limited thereto.

In embodiments, the injector system may have a number of vapor injection openings that is substantially equal to a number of substrates that may be supported by the substrate carrier, or that may be present in the process chamber. The vapor injection openings may be evenly divided or distributed amongst the different injectors (e.g., each injector has an equal number of vapor injection openings). In embodiments, each of the first and second injector may have half the total number of openings required for all substrates.

Typically, the substrates are substantially evenly spaced along the stack. In embodiments, the vapor injection openings are substantially evenly spaced to match the gaps of the substrate stack.

In embodiments, the substrate carrier may refer to a fixture, frame, or holder that supports the plurality of substrates in a spaced arrangement within the process chamber. As the substrates are separated from each other by a gap, the surface of each of the substrates may be processed simultaneously. Examples include wafer carriers used in batch reactors or other multi-substrate carriers that maintain predetermined gaps between the substrates for uniform processing. In embodiments, the substrate carrier may be a substrate boat.

In embodiments, the stack of a plurality of substrates is arranged so that multiple substrates are stacked vertically or horizontally within the substrate carrier such that each substrate is separated by a space to allow vapor flow around each substrate surface. By way of non-limiting example, such stacks are typical in vertical furnace systems, in which the substrates are stacked vertically, or batch ALD tools.

The process chamber may be a batch reactor. The process chamber can form part of a vapor processing assembly for manufacturing semiconductor devices. The substrate processing system may comprise one or more multi-station processing chambers. In some embodiments, the substrate is moved between processing stations of a multi-station substrate processing system. A process chamber may be part of a cluster tool in which different processes are performed to form an integrated circuit.

In some embodiments, the process chamber may be a CVD reactor, such as an ALD reactor. In some embodiments, the process chamber may be a high-volume manufacturing single wafer ALD reactor. Typically, the process chamber may be a batch reactor for manufacturing multiple substrates simultaneously.

The process chamber can form part of an ALD assembly. The process chamber can form part of a CVD assembly. The deposition assembly may be an ALD or a CVD deposition assembly. In some embodiments, the process chamber is part of a cluster tool. Optionally, the process chamber may contain a heater to activate reactions by elevating the temperature of one or more of the substrate and/or the reactants and/or precursors.

Any features of any embodiment of the second aspect may be independently as correspondingly described for any embodiment of any of the other aspects of the present invention.

In a third aspect, the present invention relates to an injector system for injecting a vapor into a process chamber, the injector system comprising at least one injector comprising an elongated internal conduit, an inlet along the conduit for providing the vapor into the conduit, a series of vapor injection openings, distributed along the conduit, for providing the vapor from the conduit into the process chamber, and a flow deflector at the inlet for deflecting a flow of said vapor, entering the conduit through the inlet, in a direction along the conduit.

In embodiments, the inlet may be provided along the conduit such that the vapor is provided into the conduit in a direction substantially perpendicular to the conduit, or substantially perpendicular to the elongated axis of the conduit. This arrangement improves flow distribution by redirecting the vapor along the length of the conduit. In embodiments, the at least one injector may comprise at least a first and a second injector, further comprising a vapor distributor for providing the vapor to the inlets of the injectors. This configuration with multiple injectors and a common distributor enhances uniformity across large process chambers.

In embodiments, the flow deflector may comprise a plate, arranged in a flow path of said vapor flow entering the conduit through the inlet. The plate design effectively redirects flow and prevents localized high concentration near the inlet.

Any features of any embodiment of the third aspect may be independently as correspondingly described for any embodiment of any of the other aspects of the present invention.

In a fourth aspect, the present invention relates to an injector system for injecting a vapor into a process chamber, the injector system comprising at least one injector comprising an elongated internal conduit, a series of inlets, distributed along the conduit, for providing the vapor into the conduit, and a series of vapor injection openings, distributed along the conduit, for providing the vapor from the conduit into the process chamber, and a vapor distributor for providing the vapor to the inlets of the injectors.

Any features of any embodiment of the fourth aspect may be independently as correspondingly described for any embodiment of any of the other aspects of the present invention.

In a fifth aspect, the present invention relates to a substrate processing system comprising a process chamber, and the injector system of the third or fourth aspect for providing a vapor into the process chamber.

Any features of any embodiment of the fifth aspect may be independently as correspondingly described for any embodiment of any of the other aspects of the present invention.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

### Example 1: Injector system containing two parallel injectors and flow distributor

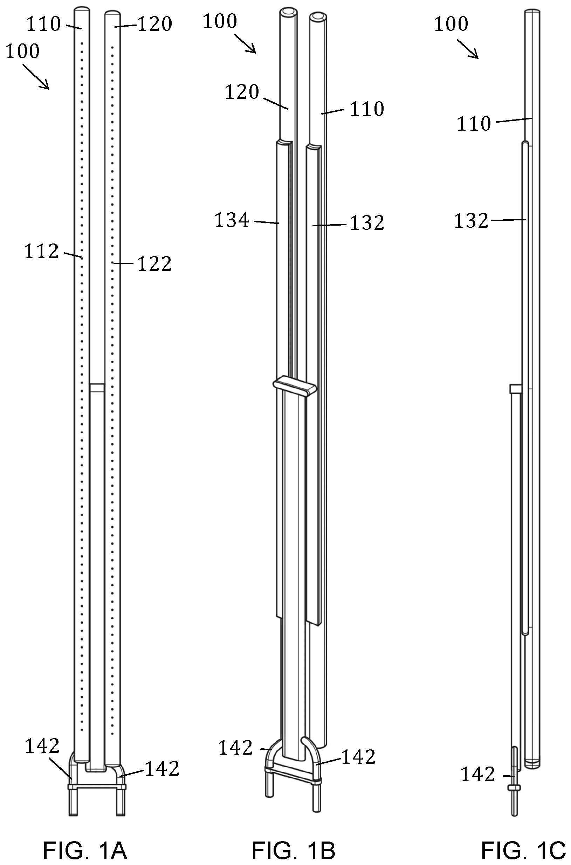

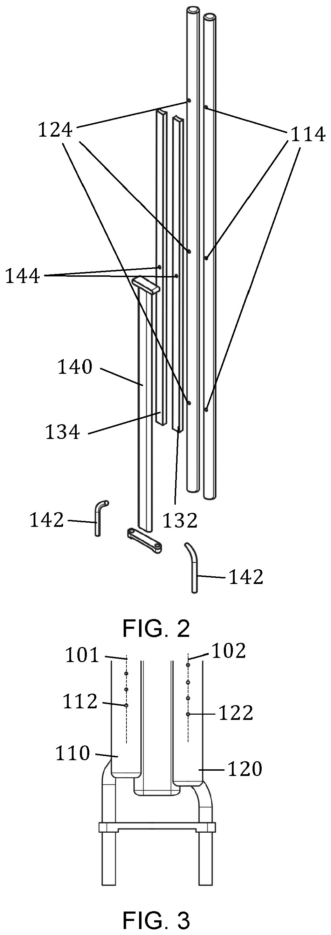

Reference is made to FIG. 1A, 1B and 1C, which is a front view, a perspective view, and a side view, respectively, of a schematic representation of an exemplary embodiment of an injector system (100) in accordance with embodiments of the present invention. Simultaneous reference is made to FIG. 2, which is an exploded view of the same injector system (100). The injector system (100) is for injecting a vapor into a process chamber, if the injector system (100) is located in the process chamber. The injector system (100) comprises a first injector (110) and a second injector (120), each comprising an elongated internal conduit. In the present example, the injectors (110, 120) are hollow cylinders, said hollow corresponding to the internal conduit. A series of inlets (114 for the first injector and 124 for the second injector) is distributed along each conduit for providing the vapor into the conduit. As may be observed in FIG. 2, for each injector, the inlets (114, 124) are distributed substantially symmetrically along the injector. As may be observed, in this example, the inlets comprise a central inlet at a midpoint of the conduit, and, in addition, a pair of inlets, wherein each inlet of the pair is located substantially equidistant from said midpoint, i.e., from said central inlet.

A series of vapor injection openings (112 for the first injector and 122 for the second injector) is distributed along the conduit for providing the vapor from the conduit into the process chamber. For each injector, the vapor injection openings (112, 122) are, in the present example, arranged at regular intervals along the conduit. This regular spacing may ensure consistent vapor distribution to the substrates. In the present example, for each injector (110, 120), the vapor injection openings (112, 122) are arranged along a straight line. This arrangement may simplify fabrication and may ensure alignment with substrates.

The injector system (100) further comprises a vapor distributor for providing the vapor to the inlets of the injectors. The vapor distributor includes a first pre-injector chamber (132) arranged parallel to the first injector (110) and a first pre-injector chamber (134) arranged parallel to the second injector (120). The vapor distributor further comprises a second pre-injector chamber (140), fluidically coupled to a central portion of the first pre-injector chamber (132, 134) of each injector (110, 120). The second pre-injector chamber (140) further comprising two inlets (142) for receiving the vapor. Each of the two inlets (142) may be fluidically coupled to the same vapor source, or to a different vapor source. When the two inlets (142) are fluidically coupled to a different vapor source, the different vapors from the different sources may mix in the second pre-injector chamber (140), and may be provided to the injectors (110, 120) as a mixture of the vapors. In the present example, two inlets (142) are present. This may be advantageous if two vapors from different vapor sources, that is, each from a different vapor source, are to be provided to the second pre-injector chamber (140): for example, a particular minimum temperature may be preferred for mixing the two vapors, wherein said minimum temperature may be provided in the second pre-injector chamber (140) (e.g., by virtue of the second pre-injector chamber 140 being present in the - optionally heated - process chamber that may be at a temperature of at least said minimum temperature, or by a separate heater provided in the second pre-injector chamber 140). Similarly, more than two inlets (142) may be provided, each connected to a different vapor source, if more than two vapors are to be provided or mixed in the second pre-injector chamber (140). However, instead, for example, only a single inlet (142) could be provided, e.g., if only a single vapor is to be provided, or if multiple vapors may be mixed before the mixed vapors are provided to the single inlet.

In the present example, the first pre-injector chamber (132, 134) contains an internal duct or conduit arranged parallel to the conduit of the injector, and fluidically coupled to the series of inlets (114, 124) of the injector. The series of vapor injection openings (112, 122) of the first (110) and second injector (120) are arranged substantially parallel to each other. The vapor injection openings (112) of the first injector (110) are distributed along the vapor injection openings (122) of the second injector (120). As may be observed, in the present example, the elongated axis of the injectors (110, 120) is vertically aligned. In the present example, the elongated axis of each of the conduits of the injectors (110, 120) is vertically aligned. The elongated axis may also be called the longitudinal axis, or the longest axis. The elongated axis of the conduit of the injector (110, 120) is typically the axis along which the series of vapor injection openings (112, 122) of the injector (110, 120) is distributed. The elongated axis of the conduit of the injector (110, 120) is typically the axis along which the series of inlets of the injector (110, 120) is distributed.

The injectors (110, 120) are located adjacent and along each other. In a direction along said series of vapor injection openings (112, 122), the openings (112) of the first injector (110) alternate with the openings (122) of the second injector (120).

FIG. 3 is a close-up front view of the injector system (100), more clearly showing the alternating arrangement of the vapor injection openings (112, 122) between the first injector (110) and the second injector (120). This view clearly shows how the openings are offset from each other such that, when viewed together, they provide a uniform distribution of injection points. The vapor injection openings (112) of the first injector (110) are positioned midway between adjacent vapor injection openings (122) of the second injector (120), creating an evenly spaced array of injection points when viewed collectively. This arrangement may be straightforwardly obtained by using substantially identical injectors (110, 120) and offsetting the complete first injector (110) with respect to the second injector (120) so as to offset the vapor injection openings (112) of the first injector (110) with respect to the vapor injection openings (122) of the second injector (120).

A first line (101) may cross the vapor injection openings (112) of the series of vapor injection openings (112) of the first injector (110), and a second line (102) may cross the vapor injection openings (122) of the series of vapor injection openings (122) of the second injector (120). The first line (101) and the second line (102) may be substantially parallel to each other.

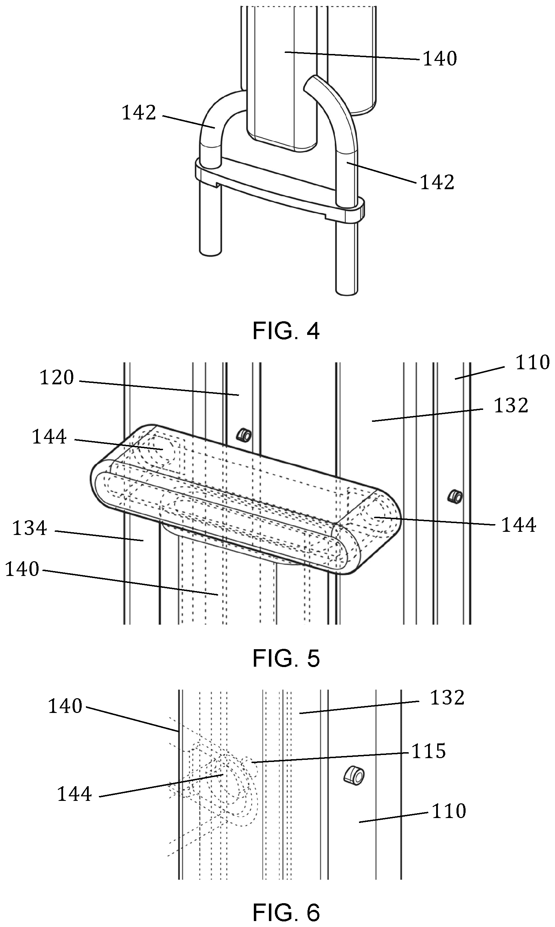

The multi-stage distribution system in accordance with embodiments of the present invention may provide a uniform vapor flow through each vapor injection opening of all injectors. FIG. 4 is a close-up perspective view of the injector system (100), highlighting the inlets (142) at the bottom of the second pre-injector chamber (140) for receiving the vapor. These inlets (142) serve as the entry points for the vapor into the distribution system. The vapor enters through these inlets (142) and is then distributed throughout the second pre-injector chamber (140) before being directed to the first pre-injector chambers (132, 134). The inlets (142) may be connected to the same vapor source, or may be connected to different vapor sources, wherein the vapor from the different sources may then be mixed in the vapor distributor, e.g., in the second pre-injector chamber (140).

FIG. 5 is a close-up perspective view of the injector system (100) showing an opening (144) that fluidically couples the second pre-injector chamber (140) (that is quasi-transparent in FIG. 5) to the first pre-injector chambers (132, 134). This opening (144) is located at a central portion of each first pre-injector chamber (132, 134; see also FIG. 2), facilitating a symmetric or uniform vapor pressure throughout the first pre-injector chambers (132, 134). The opening (144) enables the vapor to flow from the second pre-injector chamber (140) into the first pre-injector chambers (132, 134), where it is further distributed before entering the injectors (110, 120).

FIG. 6 is a close-up perspective view of one of the first pre-injector chamber (132) rendered quasi-transparent to reveal the central inlet (115) of the first injector (110). This central inlet (115) is located at a midpoint of the conduit of the injector (110) and receives vapor from the first pre-injector chamber (132). The central inlet (115) is located proximate to the opening (144) that fluidically couples the second pre-injector chamber (140) to the first pre-injector chambers (132, 134). The central inlet (115) allows vapor to enter the conduit at its midpoint. This central inlet (115) is one of the series of inlets (114, 124) distributed along the conduit. Together with other inlets, it helps achieving a symmetric distribution of vapor within the injector conduit, contributing to uniform outflow through the vapor injection openings (112, 122).

Although FIG. 6 only shows the first injector (110) and its first pre-injection chamber (132), features may be correspondingly the same for the second injector (120) and its first pre-injection chamber (134).

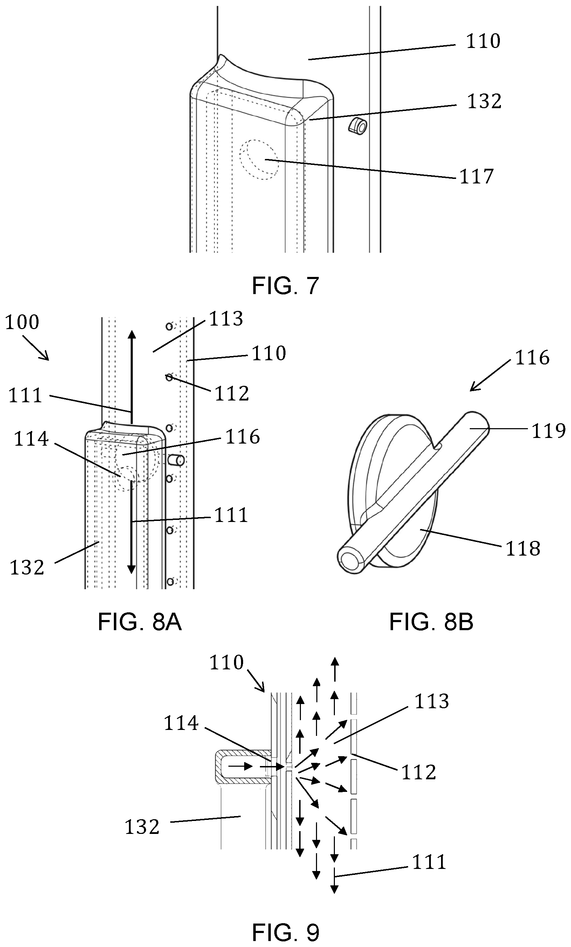

FIG. 7 is a close-up perspective view of the injector system with the first pre-injector chamber (132) rendered quasi-transparent to show an upper inlet (117) of one of the injectors (110) for receiving vapor from the first pre-injector chamber. This upper inlet (117) is one of the series of inlets (114, 124) distributed along the conduit. Together with other inlets, it helps achieving a symmetric distribution of vapor within the injector conduit, contributing to uniform outflow through the vapor injection openings (112, 122). The use of said plurality of inlets, coupled to the distributor, contributes significantly to achieving uniform vapor distribution through all vapor injection openings (112) along the entire length of the injector (110).

### Example 2: Injector system containing flow deflectors

Reference is made to FIG. 8A, which is a close-up perspective view of an exemplary injector system in accordance with embodiments of the present invention. In FIG. 8A, a first pre-injector chamber (132) and an injector (110) are rendered quasi-transparent to reveal a flow deflector (116) positioned in a conduit (113) of the injector (110), at an inlet (114) in the injector (110).

Simultaneous reference is made to FIG. 8B, which is a close-up perspective view of the flow deflector (116), which shows that the flow deflector (116) comprises a plate (118) that is to be arranged in the flow path of the vapor entering the conduit (113) through the inlet (114). The plate (118) is designed to redirect the incoming vapor flow in a direction along the conduit (113). The flow deflector (116) is supported by a pin (119) that suspends it at an appropriate position relative to the inlet (114), allowing it to effectively redirect the vapor flow. As such, the deflector plate (118) may be a fused-quartz disc welded to a quartz pin (119), inserted into an inlet (114) region by locally removing and reattaching a portion of the injector tube wall, ensuring precise positioning of the deflector and maintaining the sealed integrity of the tube.

The flow deflector (116), positioned in the conduit of the injector (110) is designed to deflect the flow of vapor entering the conduit through the inlet (114), directing the vapor to flow along the conduit or along the elongated axis of the conduit (that is, in the direction of the arrows 111) instead of allowing the vapor to flow directly toward the nearest vapor injection openings (112).

Indeed, as illustrated in FIG. 9 which shows a similar injector system, but without such a deflector, the vapor flow from the first pre-injector chamber (132) into an internal conduit (113) of an injector (110) in the absence of flow deflectors demonstrates a potential issue. As may be observed, the series of inlets (114) is located on a substantially opposite side of the conduit (113) with respect to the series of vapor injection openings (112). Therefore, without deflectors, the vapor enters the injector conduit, typically perpendicularly to the conduit (i.e., perpendicularly to the elongated axis of the conduit), through the inlet (114) and flows preferentially toward the vapor injection openings (112) nearest to the inlet (114). (The arrows 111 in FIG. 9 indicate the local nominal vapor flow direction.) This may result in non-uniform distribution of vapor flow rates through vapor injection openings (112) along the length of the injector, with higher flow rates through the openings (112) near the inlet (114) and lower flow rates through the openings (112) farther away.

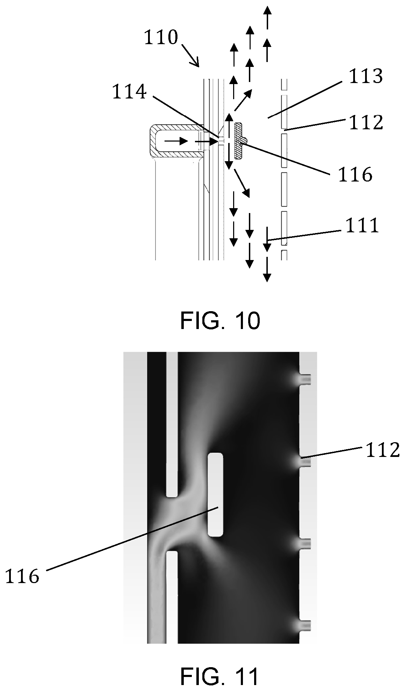

In contrast, FIG. 10 illustrates the vapor flow from the first pre-injector chamber (132) into the conduit (113) of the injector (110) when flow deflectors are present. The flow deflector (116), located at the inlet and in the flow path of the vapor entering the conduit (113), redirects the incoming vapor along the conduit, preventing it from immediately exiting through nearby vapor injection openings. (The arrows 111 in FIG. 10 indicate the local nominal vapor flow direction.) This redirection results in more uniform and consistent flow rates through all vapor injection openings (112). This redirection of flow contributes significantly to achieving uniform vapor distribution through all vapor injection openings (112) along the entire length of the injector (110). In embodiments, each injector (110, 120) may comprise a flow deflector (116, 126) at each inlet (114), arranged for deflecting a flow of said vapor, entering the conduit (113) through the inlet (114), in a direction along the conduit (113).

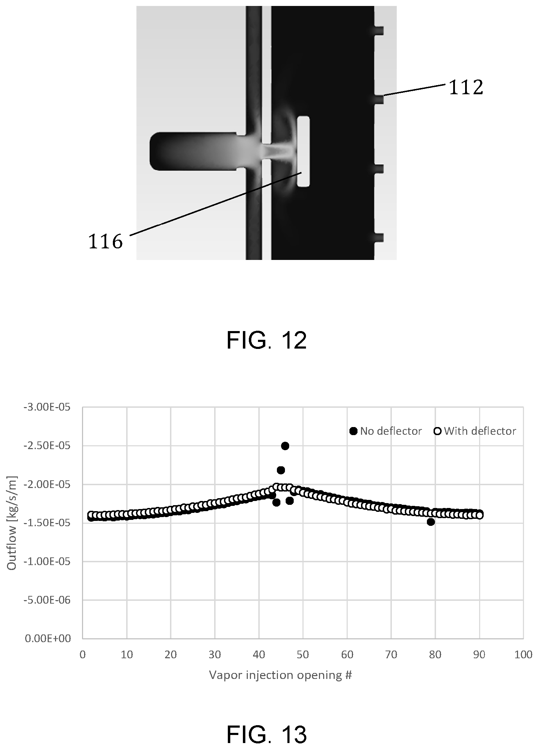

FIG. 11 and 12 show results from computational fluid dynamics (CFD) calculations for vapor flow within the injector system (100) when flow deflectors (116) are present are shown. FIG. 11 and 12 show flow patterns within the injector conduit, demonstrating how the flow deflectors contribute to achieving a more uniform distribution of vapor flow rates through the vapor injection openings (112). These CFD visualizations help illustrate the effectiveness of the flow deflectors in redirecting the vapor flow along the conduit. It may be observed that the deflector (116) in FIG. 11 is offset with respect to the inlet. In FIG. 11, the vapor does not enter the conduit completely perpendicularly with respect to the conduit, but flow under an angle into the conduit. Therefore, to position the deflector (116) into the flow path to effectively deflect the vapor, the deflector (116) is offset with respect to the inlet. In contrast, in FIG. 12, in which the vapor enters the conduit in a perpendicular direction with respect to the conduit, the deflector (116) is located directly in front of the inlet.

The graph in FIG. 13 shows an example of the outflow pattern of an injector with an inlet positioned halfway along its length, comparing performance with (white dots) and without (black dots) a flow deflector positioned in front of the inlet. The horizontal axis represents the flow injection opening along the injector (with vapor injection opening #1 at a first end of the injector and vapor injection opening #90 at a second end, different from the first end, of the injector; and with the inlet located halfway, so between vapor injection openings #45 and #46), while the vertical axis represents the outflow rate of vapor leaving the conduit through the respective injection opening. The graph clearly shows that without a flow deflector, the outflow is concentrated near the inlet position, while with a flow deflector, the outflow is more evenly distributed along the entire length of the injector.

### Example 3: Injector system containing two parallel injectors and flow deflectors

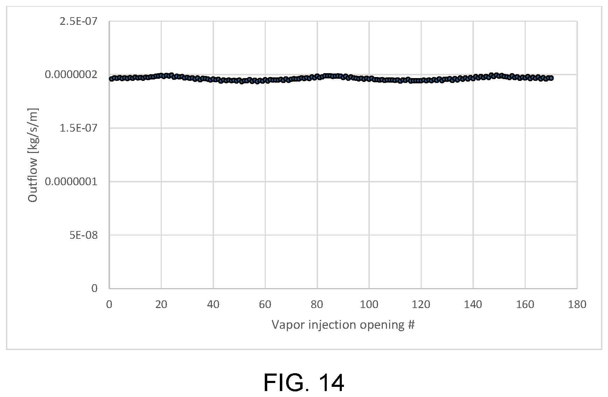

Simulations were performed of an exemplary injector system in accordance with embodiments of the present invention, containing the parallel injectors fluidically coupled to the flow distributor as in Example 1 above, and the flow deflectors at each of the inlets of the injectors as in Example 2 above. The vapor injection openings have a uniform size and shape. The simulations were performed for a typical TEOS LPCVD process using N₂ as carrier gas. The results of these simulations are shown in FIG. 14, which is a graph showing outflow rate of vapor leaving the conduit through the respective injection opening, as dependent on vapor injection opening position. The graph demonstrates clear uniformity of outflow per unit length, with variations of only about 3% assuming flow rates typical of TEOS LPCVD process. This high level of uniformity is achieved through the combination of the alternating arrangement of openings between the two injectors, the symmetric distribution of inlets, and the use of flow deflectors. The injector system is arranged so that, when vapor is provided to the vapor distributor, a volumetric flow rate of the vapor flowing through the vapor injection openings is substantially the same for each vapor injection opening. This ensures uniform deposition across all substrates in the process chamber.

### Example 4: Process chamber comprising the injector system

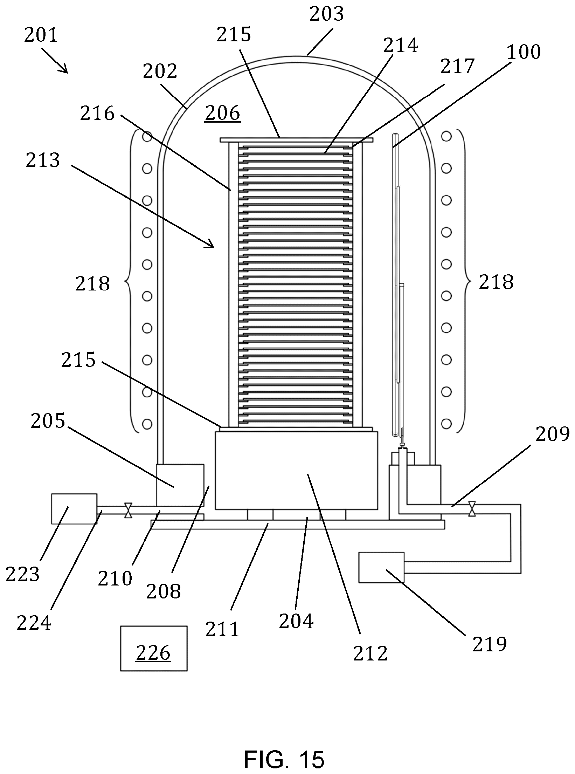

Referring to FIG. 15, a semiconductor processing apparatus (201) according to embodiments of the present invention is shown. The semiconductor processing apparatus (201) comprises a process chamber (202) which is generally bell jar shaped, having a closed top end (203), a closable bottom end (204), and an interior space (206). The semiconductor processing apparatus (201) may be a vertical furnace and the process chamber (202) may accordingly extend in a vertical direction between the top end (203) and the bottom end (204). The semiconductor processing apparatus (201) may comprise a flange (205) for at least partially supporting the process chamber (202) at the bottom end (204). The flange (205) may be generally circular in shape as viewed along the vertical direction. The flange (205) may comprise a central opening (208) and various gas inlets (209) and gas outlets (210) for providing or removing a gas from the interior space (206) respectively. The flange (205) may be configured to partially close off the bottom end (204) of the process chamber (202).

The semiconductor processing apparatus (201) comprises a doorplate (211) configured to at least partially close off the bottom end (204) of the process chamber (202). The doorplate (211) may support a pedestal (212) thereon. The pedestal (212) may be configured to support a substrate carrier (213), also referred to as a boat. In some embodiments, no pedestal may be provided and the substrate carrier (213) may be supported directly on the doorplate (211). The pedestal (212) (if included) and boat may be inserted into and removed from the process chamber (202) through the bottom end (204) by moving the doorplate (211) in a vertical direction.

The substrate carrier (213) is configured to support a plurality of substrates (214) therein. The plurality of substrates (214) may be spaced apart in a vertical direction. The substrate carrier (213) may comprise two end plates (215) spaced apart by a plurality of support rods (216). The plurality of support rods (216) may comprise a plurality of sets of slots (217) or projections for supporting the plurality of substrates, each set of slots (217) or projections being spaced apart from the other sets of slots (217) or projections in the vertical direction. Each set of slots (217) or projections being at a same vertical position forms a respective substrate receiving position.

The semiconductor processing apparatus (201) may comprise a heater for heating the process chamber (202) and thereby heating the interior space, for example in the form of heating coils (218) disposed around an outer surface of the process chamber (202).

The semiconductor processing apparatus (201) comprises at least one gas inlet (209) in the flange (205) for providing a gas or gases to the interior space (206) of the process chamber (202). The at least one gas inlet (209) may each be connected to one or more respective gas sources (219). The gas sources (219) may include process gas sources and purge gas sources. The gas inlets (209) may be categorised according to the type of gas to be provided therethrough; for example, the flange (205) may comprise one or more process gas inlets and one or more purge gas inlets.

The semiconductor processing apparatus (201) comprises at least one injector system (100) in accordance with embodiments of the present invention. The semiconductor processing apparatus (201) may further comprise at least one injector system or injector not in accordance with embodiments of the present invention. Each injector system (100) is in fluid communication with a respective gas inlet (209). The semiconductor processing apparatus (201) may comprise the same number of injector systems (100) as gas inlets (209), or may comprise fewer injector systems (100) than gas inlets (209), that is, one or more gas inlets 209 may not be connected to an injector (100). The injector (100) or each of the injector systems (100) extends in a vertical direction within the process chamber (202).

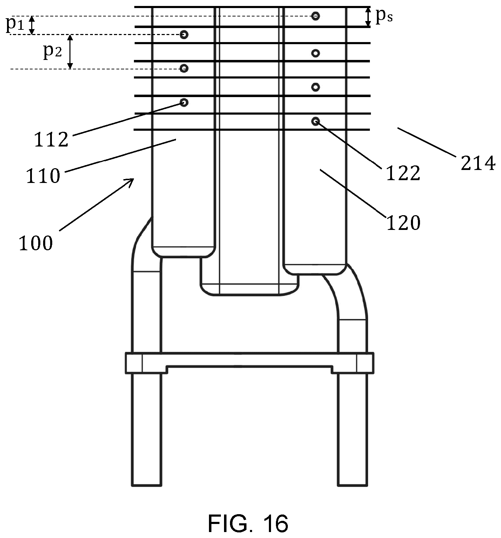

Simultaneous reference is made to FIG. 16 that is a cutaway view of part of the process chamber (201), showing part of the injector system (100) in accordance with embodiments of the present invention, and part of the substrates (214) in front of the vapor injection openings (112, 122) of the injector system (100). The injector system (100) or each of the injector systems (100) comprises a series of vapor injection openings (112, 122) through which gas or vapor may flow into the process chamber (202), the vapor injection openings (112, 122) being spaced apart in a vertical direction. As may be observed in FIG. 16, a pitch (p₁) between the vapor injection openings of the injector system (100) (e.g., a center-to-center distance of vapor injection openings 112, 122 of the first 110 and second injector 120 along a vertical direction) is equal to a pitch (pₛ) between the substrates (214). As may be observed, in the present example, said pitch (p₁) between the vapor injection openings (112, 122) of the injector system (100) is between a vapor injection opening (112) of the first injector (110) and a vapor injection opening (122) of the second injector (120). Similarly, the pitch (p₂) between the vapor injection openings (112, 122) of each injector (110, 120) of the vapor injector system (100) is twice as large as the pitch (pₛ) between the substrates (214). Similarly, the pitch (p₂) between the vapor injection openings (112, 122) of each injector (110, 120) of the vapor injector system (100) is twice as large as the pitch (p₁) between the vapor injection openings of the injector system (100).

The semiconductor processing apparatus (201) comprises at least one gas outlet (210) in the flange (205) for removing a vapor or gas, or vapor or gases, from the interior space (206) of the process chamber (202). The at least one gas outlet (210) may be in fluid communication with a vacuum pump (223) via an exhaust gas line (224).

The semiconductor processing apparatus (201) may comprise a controller (226) which may be configured to control various elements of the semiconductor processing apparatus (201). The controller (226) may comprise a memory for storing, for example, program instructions, setpoint values, characterisation data, and other data. The controller (226) may comprise a processor for executing program instructions which may be loaded from the memory. The controller (126) may be configured to receive data from sensors in the semiconductor processing apparatus (201), for example pressure sensors, temperature sensors, and/or other types of sensors. The controller (226) may be configured to control elements of the semiconductor processing apparatus (201) by sending control signals to, for example, gas flow control valves, heating elements, water cooling elements.

It is to be understood that although preferred embodiments, specific constructions and configurations, as well as materials, have been discussed herein for devices according to the present invention, various changes or modifications in form and detail may be made without departing from the scope of this invention. Steps may be added or deleted to methods described within the scope of the present invention.

## Claims

1. An injector system for injecting a vapor into a process chamber, the injector system comprising:
at least a first and a second injector, each comprising:
an elongated internal conduit,
a series of inlets, distributed along the conduit, for providing the vapor into the conduit, and
a series of vapor injection openings, distributed along the conduit,
for providing the vapor from the conduit into the process chamber, and
a vapor distributor for providing the vapor to the inlets of the injectors,
wherein the series of vapor injection openings of the first and second injector are arranged substantially parallel to each other, wherein - in a direction along said series of vapor injection openings - the openings of the first injector alternate with the openings of the second injector.

2. The injector system of claim 1, wherein each injector comprises a flow deflector at each inlet for deflecting a flow of said vapor, entering the conduit through the inlet, in a direction along the conduit.

3. The injector system of any of the previous claims, wherein, for each injector, the series of inlets is distributed substantially symmetrically along the conduit.

4. The injector system of claim 3, wherein, for each injector, the series of inlets comprises at least one pair of inlets, wherein each inlet of each pair is located substantially equidistant from a midpoint of the conduit.

5. The injector of claim 3 or 4, wherein, for each injector, the series of inlets comprises a central inlet substantially at a midpoint of the conduit.

6. The injector system of any of the previous claims, wherein, for each injector, the series of inlets is located on a substantially opposite side of the conduit with respect to the series of vapor injection openings.

7. The injector system of any of the previous claims, wherein the vapor distributor comprises:
for each injector, a first pre-injector chamber, arranged parallel to the conduit of the injector, fluidically coupled to the series of inlets of the injector, and
a second pre-injector chamber, fluidically coupled to a central portion of the first pre-injector chamber of each injector, the second pre-injector chamber further comprising an inlet for receiving the vapor.

8. The injector system of any of the previous claims, wherein, for each injector, the vapor injection openings are arranged at regular intervals along the conduit.

9. The injector system of any of the previous claims, wherein, for each injector, the vapor injection openings are arranged along a straight line.

10. The injector system of any of the previous claims, arranged so that, when vapor is provided to the vapor distributor, a volumetric flow rate of the vapor flowing through the vapor injection openings is substantially the same for each vapor injection opening.

11. A substrate processing system comprising:
a process chamber, and
the injector system of any of the previous claims for providing a vapor into the process chamber.

12. The substrate processing system of claim 11, wherein the process chamber
is configured for receiving a substrate carrier supporting a stack of a plurality of substrates separated from each other by gaps,
wherein the series of vapor injection openings of the injectors are arranged along said stack, and
wherein - in a direction along said stack - a pitch between the vapor injection openings is substantially the same as a pitch between the substrates.

13. An injector system for injecting a vapor into a process chamber, the injector system comprising:
at least one injector comprising:
an elongated internal conduit,
an inlet along the conduit for providing the vapor into the conduit,
a series of vapor injection openings, distributed along the conduit,
for providing the vapor from the conduit into the process chamber, and
a flow deflector at the inlet for deflecting a flow of said vapor,
entering the conduit through the inlet, in a direction along the conduit.

14. The injector system of claim 13, wherein the inlet is provided along the conduit such that the vapor is provided into the conduit in a direction substantially perpendicular to the conduit.

15. The injector system of claim 13 or 14, the at least one injector comprising at least a first and a second injector,
further comprising a vapor distributor for providing the vapor to the inlets of the injectors.

16. The injector system of any of claims 13 to 15, wherein the flow deflector comprises a plate, arranged in a flow path of said vapor flow entering the conduit through the inlet.

17. An injector system for injecting a vapor into a process chamber, the injector system comprising:
at least one injector comprising:
an elongated internal conduit,
a series of inlets, distributed along the conduit, for providing the vapor into the conduit, and
a series of vapor injection openings, distributed along the conduit,
for providing the vapor from the conduit into the process chamber, and
a vapor distributor for providing the vapor to the inlets of the injectors.

18. A substrate processing system comprising:
a process chamber, and
the injector system of any of claims 13 to 17 for providing a vapor into the process chamber.
